Europäisches Patentamt

European Patent Office

Office européen des brevets

(11) Publication number: **0 511 628 A2**

# EUROPEAN PATENT APPLICATION

(21) Application number: **92107207.0**

(22) Date of filing: **28.04.92**

(51) Int. Cl.⁵: **H01L 21/321**, H01L 21/28, H01L 21/336, H01L 29/788, H01L 27/102

(30) Priority: **30.04.91 US 693211**

(43) Date of publication of application:
**04.11.92 Bulletin 92/45**

(84) Designated Contracting States:
**DE FR GB IT NL**

(71) Applicant: **TEXAS INSTRUMENTS INCORPORATED**
**13500 North Central Expressway**
**Dallas Texas 75265(US)**

(72) Inventor: **Gill, Manzur**
**5310 E Plantation Oaks**
**Arcola, Texas 77583(US)**

(74) Representative: **Schwepfinger, Karl-Heinz, Dipl.-Ing. et al**
**Prinz, Leiser, Bunke & Partner Manzingerweg 7**
**W-8000 München 60(DE)**

(54) Insulator for integrated circuits formed by high-pressure oxidation.

(57) A non-volatile memory array is formed on a semiconductor layer of a first conductivity-type. Polysilicon insulated floating gates are formed over and insulated from channel regions in the surface of the semiconductor layer. Control gates are formed over and insulated from the floating gates. An inter-level insulator between each floating gate and control gate has first oxide layer over the floating gate and a silicon nitride layer over the first oxide layer. High-pressure-oxidation converts the upper portion of the silicon nitride to silicon-oxide-nitride.

FIG. 3a

EP 0 511 628 A2

FIELD OF THE INVENTION

This invention relates to semiconductor devices, such as nonvolatile semiconductor memory devices, including electrically-programmable, read-only memories (EPROMs) of the floating-gate type, and to methods for making such devices. In one form, this invention relates to oxide-nitride-oxide (ONO) inter-level insulators formed by use of a high-pressure-oxidation procedure.

BACKGROUND OF THE INVENTION

without limiting the scope of the invention, its background is described in connection with floating-gate memory arrays, as an example. Heretofore in this field, floating-gate memory arrays having floating-gate memory arrays with ONO inter-level insulators have been described, for example, in U.S. Patent No. 4,613,956 issued September 23, 1986 and assigned to Texas Instruments Incorporated.

One of the major problems faced has been caused by the fact that the upper surface of the polysilicon layer used to form floating gates is not smooth. Initially, nonvolatile memories had one silicon oxide layer forming the inter-level insulator between the floating gate and the control gate. To improve the breakdown voltage and decrease leakage caused by the asperities in the polysilicon, silicon nitride was added to the silicon oxide to smooth the upper surface of the inter-level insulator. The addition of nitride was found to be insufficient to meet the breakdown voltage and leakage requirements in most cases. Therefore, another level of grown or deposited oxide was added to fill in holes in the nitride/first-oxide layer. An inter-level insulator between floating gate and control gate formed by such an oxide-nitride-oxide process is commonly referred to as an ONO insulator.

The last oxide layer of an ONO insulator is commonly grown by exposing the nitride to steam at about 1000 degrees Celsius. This step fills in the pinholes in the lower layers, improving the dielectric breakdown, improving the data retention capability in nonvolatile memories, and minimizing charge injection from control gate to floating gate in nonvolatile memories. However, the high temperature used for this step drives implanted source-drain regions deeper into the substrate and farther into the channel regions between each source and drain regions. The high -temperature oxidation step also broadens the channel impurity profile. For smaller geometry devices, the already short channel lengths cannot be further shortened by exposure to high-temperature steps without causing decreased performance capability.

U.S. Patent 4,613,956, assigned to Texas Instruments Incorporated, discloses a method in which the final oxide layer for the ONO inter-level insulator is deposited in a pure oxygen atmosphere at 800 degrees Celsius at a low pressure of about 150 torr, which is approximately one-fifth of an atmosphere. That patent also describes a very thin oxide layer grown at atmospheric pressure during the formation of gate oxides of peripheral transistors.

Methods for high-pressure oxidation of silicon are described in Razouk et al., "Kinetics of High Pressure Oxidation of Silicon in Pyrogenic Steam", J. Electorchem. Soc., p. 2214, October 1981 and in U.S. Patent No. 4,569,117, also assigned to Texas Instruments Incorporated.

Accordingly, a needed improvement would allow a final oxide layer of an ONO inter-level insulator to be grown at decreased temperature, the decreased temperature restricting diffusion of source-drain regions farther into channel regions and reducing the broadening of channel profile.

SUMMARY OF THE INVENTION

In one general form of the invention, a grown second oxide layer of an ONO inter-level insulator of a nonvolatile memory array, such as an EPROM array, is constructed in a manner that uses a decreased temperature to minimize driving of implanted species (e.g., source-drain regions) farther into the channel region. The decreased-temperature high-pressure-oxidation procedure accomplishes the task using high-pressure steam (or high pressure steam and oxygen) at temperatures of 900 degree Celsius or less.

High-pressure-oxidation procedures are presently used at earlier stages in the process to form LOCOS regions of integrated circuits, but a high-pressure-oxidation procedure has not been used to grow the second oxide layer of an ONO inter-level insulator formed at a later stage in the construction process.

Each memory cell of a typical nonvolatile memory array is formed in a semiconductor layer of a first conductivity-type and includes a drain-column region of a second conductivity-type, a source-column region of the second conductivity type spaced from the drain-column region by a channel, a thermal insulator region over the drain-column region, a thermal insulator region over the source-column region, and a floating gate over and insulated from the channel.

The array may be of the virtual-ground type, or the source-column regions and the drain-column regions of adjacent cells may be separated by thick-field insulator regions.

The floating gate of each cell renders the cell channel non-conductive when a negative charge of sufficient magnitude resides on the floating gate.

The control gate of each cell is formed over and insulated from the floating gate so as to be capacitively coupled thereto by the ONO inter-level insulator dielectric described herein, such that upon application of predetermined programming voltages to the source, the drain and the control gate, the floating gate of a selected cell is programmed (such as with a negative charge) by channel-hot electrons.

Advantages of the invention are a construction process which produces a higher-yield of operable memory cells and an EPROM array with greater reliability.

BRIEF DESCRIPTION OF THE DRAWINGS

In the drawings:

FIG. 1 is a schematic representation, in partial block form, of a circuit using one embodiment;

FIG. 2 is a plan view of a small part of a semiconductor chip of FIG. 1 having memory cells according to one embodiment;

FIGs. 3a-3d are elevation views in section of the semiconductor device of FIG. 2, respectively taken along the lines a-a, b-b, c-c and d-d of FIG. 2;

FIGs. 4a-4d are elevation views in section of the semiconductor device of FIG. 2, taken along the lines a-a of FIG. 2 at successive stages in the manufacture thereof; and

FIGs. 5a-5b illustrate two processes for forming an insulator over polysilicon using high-pressure oxidation.

Corresponding numerals and symbols in the different figures refer to corresponding parts unless otherwise indicated.

DETAILED DESCRIPTION OF A SPECIFIC EMBODIMENT

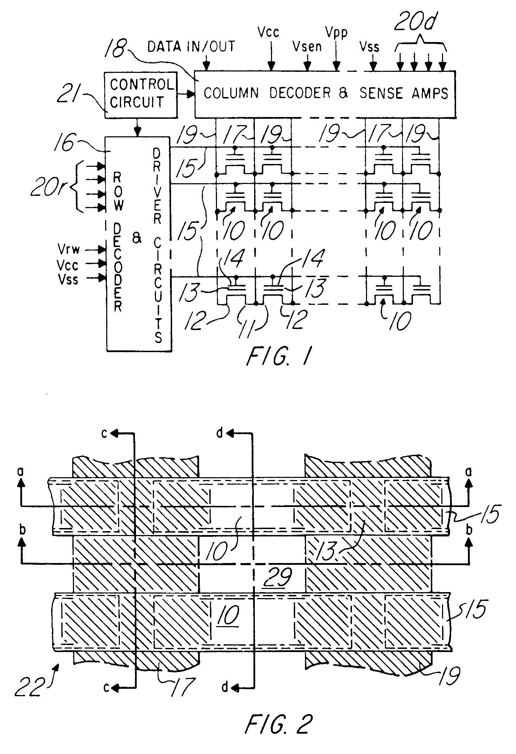

In FIG. 1, an example array of memory cells, which is a part of a memory chip such as that illustrated in FIGs. 2-4, is shown. Each cell is a floating-gate transistor 10 having a source 11, a drain 12, a floating gate 13 and a control gate 14. Each of the control gates 14 in a row of cells 10 is connected to a row line 15, and each of the row lines 15 is connected to a row line circuit 16, which includes a row line decoder, driver and related circuits. Each of the sources 11 in a column of cells 10 is connected to a source-column line 17 (which may be a virtual-ground line), and each of the source-column lines 17 is connected to a column circuit 18, which may include column decoders, virtual ground decoders and column pass gates. Each of the drains 12 in a column of cells 10 is connected to a drain-column line 19, and each of the drain-column lines 19 is connected to the column decoder 18.

In a write or program mode, the row line decoder 16 may function, in response to row line address signals on lines 20r and to signals from control circuit 21, (or a microprocessor 21) to place a preselected first programming voltage Vpp (approx. +12.5V) on a selected row line 15, including a selected control-gate conductor 14. Column decoder 18 also functions to place a second programming voltage Vrw (Vpp reduced through an impedance to approx. +5 to +10V) on a selected drain-column line 19 and, therefore, the drain region 12 of selected cell 10. The selected source-column line 17 is connected to reference potential Vss. Deselected source-column lines 17 and deselected drain-column lines 19 are floated. These programming voltages create a high current (source 11 to drain 12) condition in the channel of the selected memory cell 10, resulting in the generation near the drain-channel junction of channel-hot electrons and/or avalanche-breakdown electrons that are injected across the channel oxide to the floating gate 13 of the selected cell 10. The programming time is selected to be sufficiently long to program the floating gate 13 with a negative program charge of approximately -2V to -6V with respect to the channel region. The electrons injected into the floating gate, in turn, render the source-drain path under the floating gate 13 of the selected cell 10 nonconductive, a state which is read as a "zero" bit. Deselected cells 10 have source-drain paths under the floating gate 13 that remain conductive, and those cells 10 are read as "one" bits.

In the read mode, the row line decoder 16 functions, in response to row line address signals on lines 20r and to a signal from control circuit 21, to apply a preselected positive voltage Vcc (approx. +3 to +5 volts) to the selected row line 15 (and the selected control gate 14), and to apply a low voltage (ground or Vss) to deselected row lines 15. The column decoder 18 functions, in response to column address signals on lines 20d, causes a sense amplifier to apply a preselected positive voltage Vsen (approx. +1 to +1.5 volts) to the selected drain-column line 19. Deselected drain-column lines 19 may be allowed to float and/or the sense amplifier disconnected from deselected drain-column lines. The column decoder 18 also functions to connect all of the source-column lines 17 to ground (or Vss). The conductive or nonconductive state of the cell 10 connected to the selected drain-column line 19 and the selected row line 15 is detected by a sense amplifier connected to the DATA IN/OUT terminal. Read operation may also be performed on the source-junction side of the cells 10 to avoid read disturb.

Erasing may be accomplished by exposure to ultraviolet light, or in other embodiments, by individual electrical erasure of cells 10 or, in other embodiments, by "flash" erase.

The terms "source" and "drain", as used herein, are interchangeable. For example, the voltages applied to the source 11 regions and the drain 12 regions of the memory cells 10 may be interchanged in the read example above.

For convenience, a table of read and write voltages is given in the Table below:

TABLE

|  | Read | Write |
|---|---|---|
| Selected Row Line | 3-5V | 12.5V |
| Deselected Row Lines | 0V | 0V |
| Selected Source Line | 0V | 0V |
| Deselected Source Lines | 0V | Float |
| Selected Drain Line | 1-1.5V | 5-10V |
| Deselected Drain Lines | Float | Float |

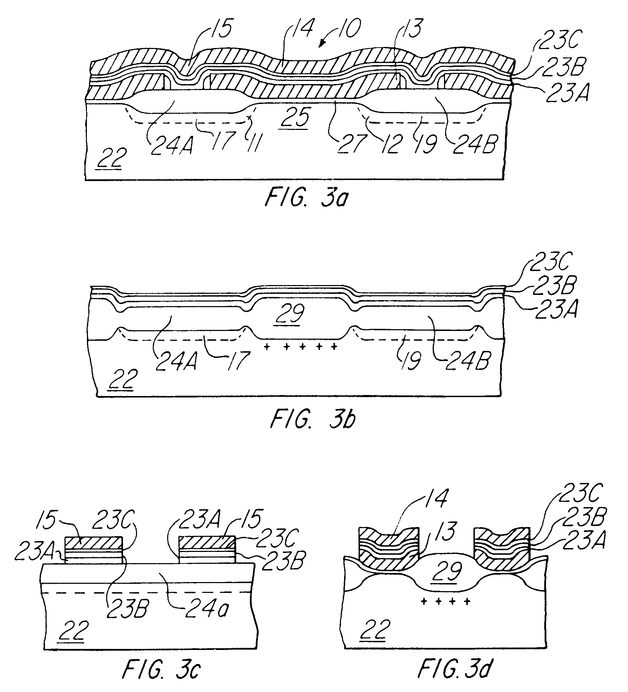

Referring now to FIGs. 2 and 3a-d, an array of electrically-programmable memory cells 10 is shown formed in a face of a semiconductor body 22, which may be a silicon substrate layer. Only a very small part of the substrate 22 is illustrated, it being understood that these cells 10 are part of an array of a very large number of such cells 10. A number of control gates 14/row lines 15 are formed by second-level polycrystalline silicon (polysilicon) strips extending along the face of the substrate 22. Control gates 14 are separated from floating-gates 13 by ONO inter-level insulator layers 23A-C. Source-column regions or lines 17 are formed beneath first thermal insulator regions 24A in the face. Drain-column regions or lines 19 are formed beneath second thermal insulator regions 24B in the face. Drain-column lines 19 are parallel to and spaced from source-column lines 17. These buried column regions or lines 17,19 include the sources 11 for each of the cells 10 and include the drains 12 for each cells 10. A floating-gate 13 for each cell 10 is formed by a first-level polysilicon layer extending across a channel 25 between spaced-apart source 11 and drain 12. Each floating-gate 13 also extends over at least parts of thermal insulator regions 24A and 24B. A gate insulator 27, such as an oxide layer, is formed over the channel 25. The two "horizontal", or row-direction, edges of the floating-gate layer 13 for a cell 10 are aligned with the edges of a row line 15. For explanatory purposes, the width of the floating gates 13 is illustrated in FIG. 2 as being slightly narrower that the width of the control gates 14.

The capacitance between control-gate layer 14 and floating-gate layer 13, compared to the capacitance between floating-gate layer 13 and source 11 or substrate 22, may be made more favorable by extending the floating-gate layer 13 out across portions of thermal insulator regions 24A and 24B. Therefore, a large fraction of the programming voltages applied between control gate 14 and source-column line 17 will appear between floating-gate layer 13 and source-column lines 17. The cell 10 is referred to as "contact-free" in that no source/drain contact is needed in the vicinity of cell 10 itself.

As illustrated in FIGs. 2, 3b and 3d, the channels of cells 10 in adjacent rows may be electrically isolated by LOCOS field oxide regions 29. In the alternative, the channels of adjacent cells 10 may be electrically isolated by junction isolation using a P-type dopant in the same region as the LOCOS field oxide regions 29 as explained, for example, in co-pending U.S. Patent Application Ser. No 07/494,051, also assigned to Texas Instruments Incorporated.

Note that the array of cells 10 is of the "virtual-ground-circuit" type. That is, columns of cells 10, or of pairs of cells 10, are not isolated by thick-field oxide insulators. While the array is shown for the purposes of illustration as having cells 10 sharing common source-column lines 17 and sharing common drain-column lines 19, the array may be constructed with dedicated source lines.

When using virtual-ground architecture, field oxide strips may also be grown parallel to where the column lines 17 and 19 are to be formed, the field oxide strips located every 16, 32 or 64 column lines. The field oxide (not shown) assures that the voltage of floated deselected column-lines 17 and 19 float up to the voltage of the selected column-lines.

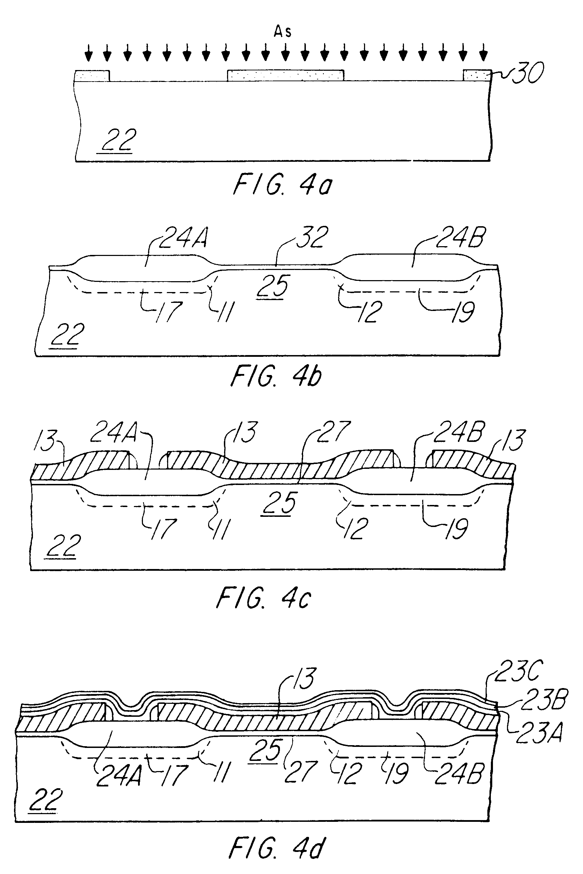

A method of making the device of FIGS. 1, 2 and 3a-3d will be described in reference to FIGs. 4a-4d, 3a and 5a-5b. The starting material is a slice of P-type silicon of which the (P-) epitaxial semiconductor layer or substrate 22 is only a very small portion. The slice is perhaps 6 inches in diameter, while the portion shown in FIGs. 2, 3a-d and 4a-e is only a few microns wide. A number of process steps would be performed to create transistors peripheral to the array, and these will not be discussed here. For example, the memory device may be of the complementary field-effect type having N-wells and P-wells formed in the substrate 22 as part of a prior process to create peripheral transistors. For fabricating the array, a layer of pad oxide is grown or deposited on the face of the substrate 22. A silicon-nitride layer is then deposited over the pad-oxide layer using low pressure chemical vapor deposition. The pad-oxide and silicon nitride layers are then patterned and plasma-etched to expose areas where thick-field insulators 29 are to be formed and to expose areas where any field oxide strips or columns are to be formed. A boron implant at a dose of about $8 \times 10^{12} cm^{-2}$ is performed to create a P+ channel stop region that will isolate the channel 25 regions of one row from the channel 25 regions of adjacent rows. After removing the photoresist, the thick-field insulator regions are thermally grown in a localized oxidation process to a thickness of about 6000-10000 Angstroms by exposure to steam at about 900°C and one atmosphere of pressure for several hours. Alternatively, a high-pressure-oxidation procedure may be used to decrease the oxidation time. Following oxidation, any nitride converted to oxide is removed, followed by removal of the silicon nitride and the pad oxide. A thin oxide (not shown) is then grown to eliminate the Kooi effect. In a step to be described below, an arsenic implant into the substrate 22 is made through this thin oxide.

As illustrated in FIG. 4a, a layer 30 of photoresist is formed on the surface of P-type substrate layer 22. The photoresist 30 is patterned to define active device areas for EPROM or EEPROM cells 10 and act as an implant mask for selectively doping column lines in substrate layer 22 with an arsenic implant As at a dose of about $6 \times 10^{15} cm^{-2}$ and at an energy of about 135 KeV. The arsenic implant As creates source-column regions or lines 17, including sources 11, and creates drain-column regions or lines 19, including drains 12. Following the implant of source-column lines 17 and drain-column lines 19, photoresist layer 30 is removed. Then oxide removal, clean-up and implant anneal steps are performed.

Referring to FIG. 4b, an oxidation step is performed with steam at 800-900°C to differentially grow thermal insulator regions 24A and 24B. The thermal oxide regions 24A and 24B will be grown to a thickness of approximately 1000 to 3000 Angstroms. At the same time, a new oxide insulator layer 32 between the drains 12 and the sources 11 is grown to a thickness of approximately 150-300 Angstroms.

At this point, a self-aligned threshold-voltage-adjust implant may be performed in the channel area 25 between thermal insulator regions 24A and 24B.

Referring to FIG. 4c, oxide insulator 32 is etched completely away and regrown or otherwise formed over the structure using conventional techniques to form a relatively thin insulator layer 27 approximately 100 Angstroms thick. A first polycrystalline silicon layer ("poly 1"), which will become floating gates 13, is deposited over the face and is doped to be N+. The first polysilicon layer is patterned with a photoresist and etched to form floating-gate strips parallel to the column lines 17 and 19, followed by a photoresist strip and clean-up. Next, sidewall oxide may be formed on the edges of the strips that will form floating gates 13 using conventional procedures.

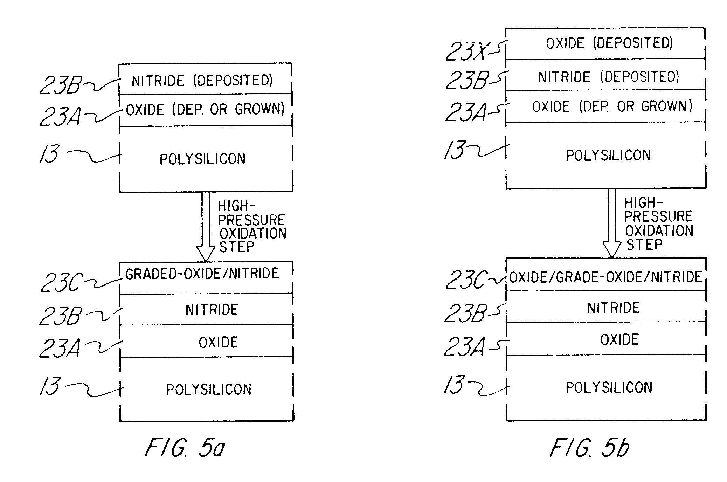

Referring now to FIG. 4d and 5a-5b, inter-level insulator layers 23A-C are then formed over the structure, the structure including first polysilicon strips 13. Inter-level insulator layer 23A may be a deposited or grown silicon oxide layer. Inter-level insulator 23B is a deposited silicon nitride layer. Inter-level insulator layer 23C is a silicon oxide layer partially converted from silicon nitride using a high-pressure-oxidation process. The high-pressure-oxidation process may be, for example, exposure to steam at 800 to 900 degrees Celsius in a pressurized chamber at pressures exceeding one atmosphere. For example, the pressure may vary from 5 to 25 atmospheres. The equivalent oxide thickness of inter-level insulator layers 23A-C may be in the range of 150 to 300 Angstroms.

As illustrated in FIG. 5a, the high-pressure oxidation step may be performed directly after deposit of the nitride layer 23B. As illustrated in FIG. 5b, an optional oxide layer 23X may be deposited over nitride layer 23B prior to performing the high-pressure oxidation step. Using the procedure of FIG. 5a, a graded-oxide/nitride layer 23C is formed. Using the procedure of FIG. 5b, an oxide/graded-oxide/nitride layer 23C is formed.

The relative thicknesses of layers 23A, 23B and 23C may be adjusted using appropriate process conditions. A typical range of thickness of layers 23A and 23B is 25 to 150 Angstroms. A typical range of thickness for layer 23C is 10 to 100 Angstroms.

The high-pressure-oxidation furnace used for this step may be a different high-pressure-oxidation furnace than that used during earlier steps in the construction to eliminate contamination of the high-pressure-oxidation furnace used in those earlier steps.

Referring again to FIG. 3a, a second polycrystalline silicon layer ("poly 2"), which will become control gates 14/row lines 15 is then deposited over the face of the slice and is highly doped to be N +. After deglazing and patterning, a stack etch of (i) the second polysilicon layer 14,15, (ii) the inter-level insulator layers 23A-C, and (iii) the first polysilicon strips 13 is performed. This stack etch defines a plurality of elongated control gates 14/row lines 15 that run substantially parallel to each other and at an angle to column lines 17, 19 and 21, as shown in FIGs. 3 and 4b-4d. This same stack etch separates and defines the remaining edges of the floating gates 13.

The programming voltage Vpp, the capacitive coupling between the control-gate 14 and the floating-gate 13, and the gate insulator 27 thickness should be selected such that write-disturb does not occur. That is, the coupling and the insulator thicknesses should be such that no charge gain or charge loss occurs in deselected cells 10 during programming operations. Excessive unintended charge gain or charge loss can result in unintended data gain or data loss.

Peripheral logic CMOS devices may be completed after this step. An oxide layer may be grown or formed after this process on the sides and top of the stack for improved data retention. A borophosphosilicate glass (BPSG) layer (not shown) may then be deposited over the face of the slice. Off-array contacts may be made through the BPSG layer, as well as on-array contacts that are made from metal bitlines to respective diffused regions periodically in a column-direction. In addition, metal contacts to row lines 15 are made. The metal bitlines are formed on the BPSG layer to run over and be parallel to diffused regions. This is followed by a protective overcoat process.

While the preferred embodiment described in detail hereinabove has been an EPROM device structure, ONO structures may be used in other devices, including DRAMs, linear integrated circuits (perhaps with switched capacitors), EEPROMS, Flash EPROMs and other floating-gate-type memories. It is to be understood that the scope of the invention also comprehends embodiments different from those described, yet within the scope of the claims.

While the invention has been described with reference to an illustrative embodiment, this description is not meant to be construed in a limiting sense. Various modifications and combinations of the illustrative embodiment, as well as other embodiments of the invention, will be apparent to persons skilled in the art upon reference to the description. It is, therefore, intended that the appended claims encompass any such modifications or embodiments.

## Claims

1. A method for fabricating an insulator on a doped polysilicon layer at a face of a semiconductor layer of a first conductivity-type, comprising:

   forming an oxide insulator layer on said doped polysilicon layer;

   depositing a layer of silicon nitride over said first oxide insulator layer; and

   using a high-pressure-oxidation Process to grow a graded silicon dioxide/silicon nitride layer over said silicon nitride layer.

2. The method of Claim 1, including depositing a silicon dioxide layer over said deposited silicon nitride layer, wherein said high-pressure-oxidation process grows a silicon dioxide/graded silicon dioxide/nitride layer.

3. The method of Claim 1, including forming a gate insulator layer over said semiconductor layer prior to forming said doped polysilicon layer.

4. The method of Claim 1, including selectively doping said semiconductor layer with at least one dopant of a second conductivity-type opposite said first conductivity-type to create drain-column lines including drains and to create source-column lines including sources, said sources spaced from said drains by channels.

5. The method of Claim 1, including

   selectively doping said semiconductor layer with at least one dopant of a second conductivity-type opposite said first conductivity-type to create drain-column lines including drains and to create source-column lines including sources, said sources spaced from said drains by channels; and

   differentially growing first thermal insulator regions over said drain-column lines and second thermal insulator regions over said source-column lines such that said sources diffuse beyond said second thermal insulator regions.

6. The method of Claim 1, including

selectively doping said semiconductor layer with at least one dopant of a second conductivity-type opposite said first conductivity-type to create drain-column lines including drains and to create source-column lines including sources, said sources spaced from said drains by channels; and

differentially growing first thermal insulator regions over said drain-column lines and second thermal insulator regions over said source-column lines such that said sources diffuse beyond said second thermal insulator regions;

forming thick field insulator regions prior to said selective doping step, said thick field oxide region positioned between said channel regions and between said source-column and said drain-column lines.

7. The method of Claim 1, including selectively etching said doped polysilicon layer and said insulator layer to define floating gate strips.

8. The method of Claim 1, including

selectively etching said doped polysilicon layer and said insulator layer to define floating gate strips; and

forming a second doped polysilicon layer over said face.

9. The method of Claim 1, including

selectively etching said doped polysilicon layer and said insulator layer to define floating gate strips;

forming a second doped polysilicon layer over said face; and

selectively etching said second doped polysilicon layer, said insulator layer and said floating gate strips to define row lines and floating gates.

10. A nonvolatile memory cell, comprising:

a semiconductor layer of a first conductivity-type;

a polysilicon insulated floating gate over and insulated from a channel region in the surface of said semiconductor layer;

a control gate over and insulated from said floating gate; and

an inter-level insulator between said floating gate and said control gate, said inter-level insulator comprising a first oxide layer over said floating gate, a deposited silicon nitride layer over said first oxide layer and a high-pressure-oxidation-grown graded silicon dioxide/silicon nitride layer over said silicon nitride layer.

11. A nonvolatile memory array, comprising:

a semiconductor layer of a first conductivity-type;

polysilicon insulated floating gates, each floating gate over and insulated from a channel region in the surface of said semiconductor layer;

control gates, each control gate over and insulated from a said floating gate; and

inter-level insulators, each inter-level insulator between a said floating gate and a said control gate, each said inter-level insulator comprising a first oxide layer over said floating gate, a deposited silicon nitride layer over said first oxide layer, and a high-pressure-oxidation-grown graded silicon oxide/nitride layer over said deposited silicon nitride layer.

12. The structure of either of Claims 10 or 11, including source and drain regions at each end of said channel region, wherein said source and drain regions are buried under thermal insulator regions.

13. The structure cell of either Claims 10 or 11, including source and drain regions at each end of said channel region, wherein said source and drain regions are buried under thermal insulator regions and wherein said floating gate extends at least partially over said thermal insulator regions.

14. The structure cell of either of Claims 10 or 11, including at least one thick field insulator region adjacent said channel.

7

FIG. 1

FIG. 2

FIG. 3a

FIG. 3b

FIG. 3c

FIG. 3d

FIG. 4a

FIG. 4b

FIG. 4c

FIG. 4d

| 23B | NITRIDE (DEPOSITED) |
| 23A | OXIDE (DEP. OR GROWN) |
| 13 | POLYSILICON |

HIGH-
PRESSURE
OXIDATION
STEP

| 23C | GRADED-OXIDE/NITRIDE |
| 23B | NITRIDE |
| 23A | OXIDE |
| 13 | POLYSILICON |

*FIG. 5a*

| 23X | OXIDE (DEPOSITED) |
| 23B | NITRIDE (DEPOSITED) |
| 23A | OXIDE (DEP. OR GROWN) |
| 13 | POLYSILICON |

HIGH-
PRESSURE
OXIDATION
STEP

| 23C | OXIDE/GRADE-OXIDE/NITRIDE |
| 23B | NITRIDE |
| 23A | OXIDE |
| 13 | POLYSILICON |

*FIG. 5b*